# FASCICULE DE BREVET EUROPEEN

(11) **EP 0 565 391 B1**
(45) Date de publication et mention de la délivrance du brevet: **04.11.1998**
(21) Numéro de dépôt: 93400577.8
(22) Date de dépôt: 05.03.1993
(51) Int. Cl.: H01L 25/065, H01L 21/60, H01L 21/98

(54) **Procédé et dispositif d'encapsulation en trois dimensions de pastilles semi-conductrices**
Verfahren und Vorrichtung zur Verkapselung von dreidimensionalen Halbleiterplättchen
Method and device for encapsulation of three-dimensional semi-conductor chips

(30) Priorité: 10.03.1992 FR 9202846
(43) Date de publication de la demande: 13.10.1993
(73) Titulaire: THOMSON-CSF, 75008 Paris (FR)
(72) Inventeur: Val, Christian, F-92402 Courbevoie Cedex (FR)
(74) Mandataire: Benoit, Monique

(56) Documents cités:
- EP-A- 0 490 739
- IEEE TRANSACTIONS ON COMPONENTS,HYBRIDS,AND MANUFACTURING TECHNOLOGY vol. 13, no. 4, Décembre 1990, NEW YORK US pages 814 - 821 CH. VAL ET AL.: '3-D INTERCONNECTION FOR ULTRA-DENSE MULTICHIP MODULES'
- PATENT ABSTRACTS OF JAPAN vol. 013, no. 366 (E-806)15 Août 1989 & JP-A-01 123 427 ( MITSUBISHI ELECTRIC CORP. ) 16 Mai 1989
- PROCEEDINGS OF THE 40TH ELECTRONIC COMPONENTS & TECHNOLOGY CONFERENCE 20 Mai 1990, LAS VEGAS, NEVADA US pages 540 - 547 CH. VAL ET AL.: '3D INTERCONNECTION FOR ULTRA-DENSE MULTICHIP MODULES'
- PATENT ABSTRACTS OF JAPAN vol. 015, no. 223 (E-1075)7 Juin 1991 & JP-A-03 064 934 ( NEC CORP. ) 20 Mars 1991
- ELECTRONIC ENGINEERING vol. 62, no. 761, Mai 1990, LONDON GB pages 49 - 57 'SEMICON EUROPA - THE SHAPE OF THINGS TO COME' PAGE 50,PAGE 52;
- PATENT ABSTRACTS OF JAPAN vol. 015, no. 315 (E-1099)12 Août 1991 & JP-A-03 116 860 ( HITACHI LTD ) 17 Mai 1991
- PATENT ABSTRACTS OF JAPAN vol. 011, no. 227 (E-526)23 Juillet 1987 & JP-A-62 045 159 ( HITACHI VLSI ENG CORP ) 27 Février 1987
- PATENT ABSTRACTS OF JAPAN vol. 014, no. 178 (E-0915)10 Avril 1990 & JP-A-02 031 454 ( HITACHI LTD ) 1 Février 1990

## Description

La présente invention a pour objet un procédé et un dispositif d'encapsulation en trois dimensions de pastilles semi-conductrices, chacune des pastilles contenant par exemple un composant électronique, un circuit intégré, ou un capteur, cette encapsulation visant à présenter une bonne évacuation thermique par conduction.

La réalisation des systèmes électroniques actuels, tant civils que militaires, doit tenir compte d'exigences de plus en plus grandes de compacité, du fait du nombre de plus en plus élevé de circuits mis en oeuvre.

Dans cette recherche de plus grande compacité, il a déjà été proposé de réaliser des empilements en trois dimensions de circuits intégrés comme par exemple décrit dans le brevet américain n° 4.706.166. Selon cette réalisation, les pastilles sont disposées sur un circuit imprimé, accolées les unes aux autres perpendiculairement au circuit imprimé; les plots de connexion de chacune des pastilles sont ramenés sur un même bord de la pastille; ce côté est disposé sur le circuit imprimé et les connexions avec ce dernier y sont réalisées. Toutefois, cet arrangement présente des limitations notamment liées au nombre de plots qu'il est matériellement possible de disposer sur un seul côté d'une pastille semi-conductrice; en outre, il est onéreux du fait que les pastilles ne sont pas standard (la disposition des plots doit être modifiée); de plus, les connexions ainsi réalisées sont peu accessibles et de plus non visibles, ce qui en limite l'utilisation. Enfin, dans certaines applications peut se poser un problème d'évacuation thermique. Classiquement, celle-ci peut s'effectuer par conduction ou convexion ; dans la réalisation décrite ci-dessus, l'évacuation thermique par conduction est limitée du fait qu'elle ne peut s'effectuer que par les plots de connexion électrique au circuit imprimé, plots qui sont de section réduite et en nombre réduit; un tel dispositif exige donc, pour fonctionner de façon satisfaisante, un refroidissement par convexion. Toutefois, dans certaines applications, un tel refroidissement est difficile voire impossible à mettre en oeuvre, notamment dans les applications avioniques ou spatiales.

Il est par ailleurs connu de l'article "3-D Interconnection for Ultra-Dense Multichip Modules" de C. Val et al. paru dans IEEE Transactions on Components, Hybrids and Manufacturing Technology, vol. 13, N° 4, pages 814-821, 1990, une technologie d'empilement et d'interconnexion de pastilles semi-conductrices, ainsi que du document "Patents Abstracts of Japan, vol. 13, n° 366 (E-806), 15th August 1989, JP-A- 01 123 427, une méthode pour positionner d'un seul côté les broches de connexion d'un boîtier pour pastille semi-conductrice.

La présente invention a pour objet une encapsulation en trois dimensions de circuits intégrés qui permette une bonne évacuation thermique par conduction, tout en restant peu onéreuse.

A cet effet, les plots de chacune des pastilles sont prolongés à l'aide de moyens de connexion vers, au maximum, trois côtés de la pastille, dégageant de la sorte le quatrième côté. Les pastilles sont empilées les unes sur les autres, puis reliées à des moyens d'évacuation thermique par leur quatrième côté, permettant ainsi un refroidissement par conduction.

Plus précisément, l'invention a pour objet un procédé d'encapsulation en trois dimensions de pastilles semi-conductrices tel que défini par la revendication 1. Elle a également pour objet un dispositif d'encapsulation en trois dimensions de pastilles semi-conductrices tel que défini par la revendication 11.

D'autres objets, particularités et résultats de l'invention ressortiront de la description suivante, donnée à titre d'exemple et illustrée par les dessins annexés, qui représentent:
- la figure 1, une vue de dessus d'une pastille et de ses moyens de connexion entrant dans la formation du dispositif selon l'invention ;
- la figure 2, une vue éclatée et partielle du dispositif selon l'invention ;
- les figures 3a et 3b, deux vues en coupe du dispositif selon l'invention ;
- la figure 4, une vue en perspective de l'empilement réalisé selon l'invention ;
- la figure 5, une vue en coupe du dispositif selon l'invention relié à des moyens d'évacuation thermique ;
- la figure 6, une vue en perspective fractionnaire d'un circuit imprimé portant plusieurs dispositifs selon l'invention ;
- la figure 7, un exemple de réalisation de l'interconnexion des pastilles ;
- la figure 8, une variante de réalisation des moyens de connexion d'une pastille utilisés dans le dispositif selon l'invention ;
- les figures 9a et 9b, d'autres variantes de réalisation des moyens de connexion d'une pastille.

Sur ces différentes figures, les mêmes références se rapportent aux mêmes éléments. En outre, pour la clarté des dessins, l'échelle réelle n'a pas été respectée.

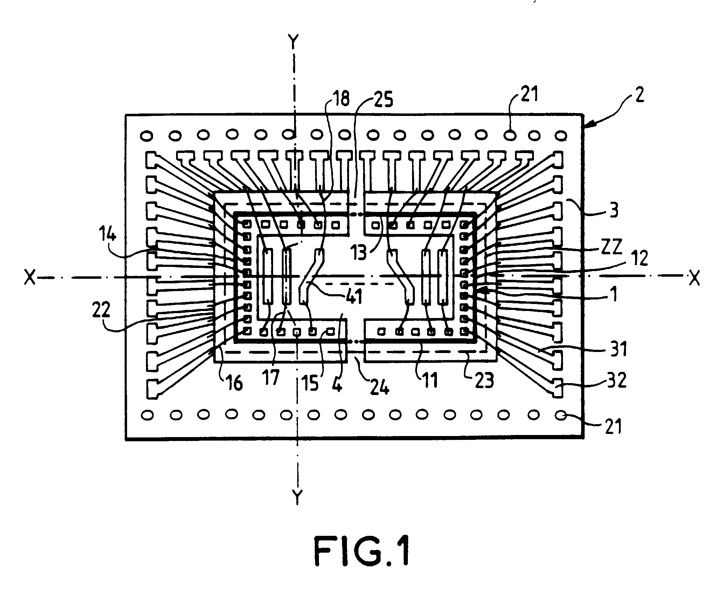

La figure 1 représente donc une vue de dessus d'une pastille et de ses moyens de connexions.

Sur cette figure, on a représenté une pastille semi-conductrice 1 dans laquelle peut être réalisé tout composant électronique, circuit intégré ou capteur. La pastille est par exemple rectangulaire et ses quatre côtés sont repérés respectivement 11, 12, 13 et 14. La face supérieure de cette pastille, visible sur la figure, porte des plots 15 d'entrées sorties électriques de l'élément contenu dans la pastille, disposés par exemple sur ses quatre côtés.

Selon l'invention, on relie chacun des plots 15 à des moyens de connexion permettant de diriger ces connexions vers au maximum trois côtés de la pastille, dégageant de la sorte le quatrième côté, le côté 11 dans l'exemple de la figure 1. Les moyens de connexion comportent un film isolant 2, de préférence mince, réalisé par exemple en polyimide ou polyester, et dans lequel est pratiquée une découpe 23, laissant subsister un cadre 3 et une partie centrale 4 reliée au cadre par deux languettes 24 et 25. Les bords du cadre 3, par exemple deux de ses bords, comportent des trous 21, par exemple rectangulaires ou oblongs, permettant le guidage et le positionnement précis du film 2 sur une machine de câblage automatique par exemple. Le cadre 3 comporte en outre un ensemble de plots 32 disposés au voisinage de la périphérie du cadre 3 et ce, selon l'invention, sur trois côtés au maximum, laissant le côté situé du côté 11 de la pastille 1 libre. Ces plots 32 sont reliés au bord intérieur 22 du cadre 3 par des dépôts conducteurs, ou pistes, 31 réalisés sur le film 2. Les plots 32 sont utilisés par exemple pour le test et le déverminage des pastilles semiconductrices, avant leur empilement. La partie centrale 4 comporte également des pistes repérées 41, rectilignes ou non.

Les plots 15 situés sur les côtés 12, 13 et 14 de la pastille 1 sont reliés directement aux pistes 31 du cadre 3, au voisinage du bord intérieur 22, à l'aide d'un conducteur 16, qui peut être un fil comme représenté sur la figure ou un ruban. Ceux des plots 15 qui sont situés sur le côté 11 sont reliés par des conducteurs 17 (fils ou rubans) à une extrémité des pistes 41 portées par la partie centrale 4, l'autre extrémité de ces pistes étant reliée par des conducteurs 18 (fils ou rubans) aux pistes 31 situées par exemple sur le côté du cadre 3 qui est à l'opposé du côté 11. Ces opérations peuvent typiquement être réalisées à l'aide de machines de câblage automatique, utilisées par exemple pour câbler les pastilles semi-conductrices dans leur boîtier.

Il apparaît ainsi que l'un des côtés de la pastille 1 (le côté 11) a été dégagé de toute connexion. Ce côté dégagé est utilisable pour l'évacuation thermique par conduction, comme expliqué plus loin. Dans cette optique, il est préférable de dégager un grand côté du rectangle. Mais, bien entendu, un ou plusieurs autres côtés peuvent être également dégagés, en fonction des utilisations.

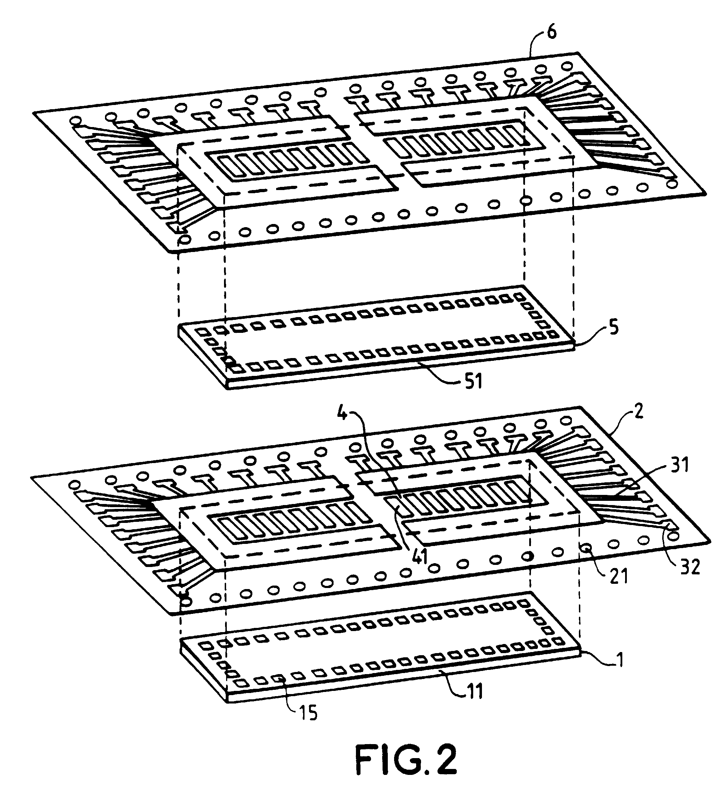

Selon l'invention, une pluralité de telles pastilles et leurs moyens de connexions sont empilés les uns au dessus des autres, comme illustré sur la vue éclatée de la figure 2 pour deux pastilles.

Sur la figure 2, on retrouve la pastille semi-conductrice 1 et ses moyens de connexion, formés par le film isolant 2 et ses pistes et plots conducteurs 31, 41 et 32. Sur cette figure 2, les conducteurs 16, 17, et 18 n'ont pas été représentés. On a représenté également une seconde pastille semi-conductrice, repérée 5, à laquelle sont associés des moyens de connexion, constitués de façon analogue à ceux de la pastille 1 par un film diélectrique 6 comportant un cadre et une partie centrale, sur lesquels sont disposés des pistes et des plots. Les éléments 1, 2, 5 et 6 sont empilés les uns sur les autres et les pastilles 1 et 5 sont disposées de sorte que leurs côtés dégagés (11 pour la pastille 1, 51 pour la pastille 5) soient situés du même côté de l'empilement ainsi réalisé.

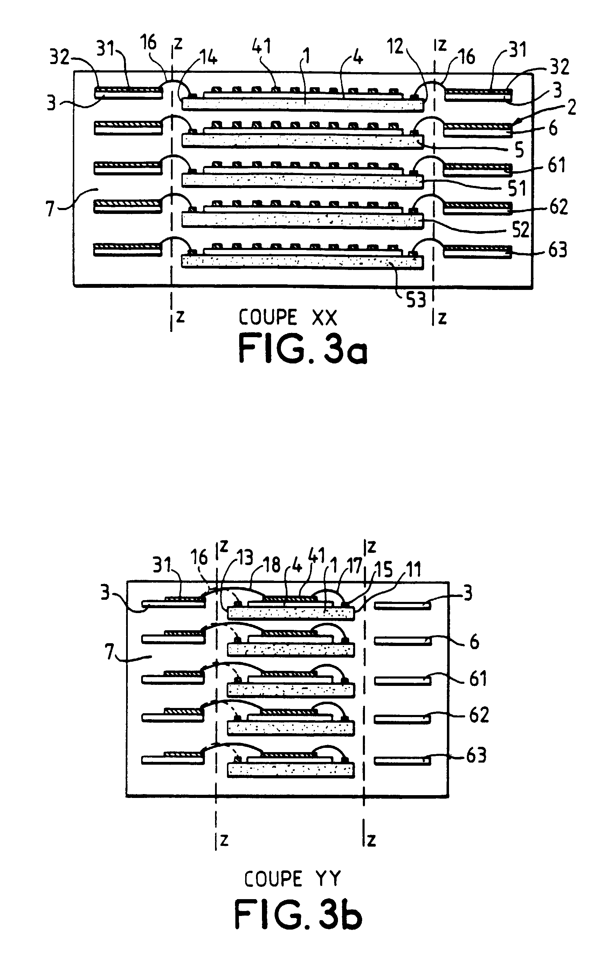

La figure 3a représente une vue en coupe de l'empilement selon l'invention, réalisée selon un axe XX illustré sur la figure 1, normal aux côtés 12 et 14 des pastilles.

Sur cette figure, on retrouve la pastille semi-conductrice 1 munie de ses moyens de connexion, à savoir pistes (31 et 41), plots (32) et conducteurs (16). Cet ensemble constitue par exemple la couche supérieure d'un empilement de cinq pastilles, les autres pastilles étant repérées 5, 51, 52 et 53, chacune munie de ses moyens de connexion portés par un film isolant (6, 61, 62 et 63). L'ensemble est solidarisé à l'aide d'un matériau isolant 7, par exemple une résine époxy. Pour la clarté de la figure, les matériaux isolants (7, 3, 6, 61-63) n'ont pas été hachurés bien que vus en coupe.

L'empilement est ensuite découpé selon une ligne ZZ de la figure 1 passant dans la découpe 23, entre la partie centrale 4 et le cadre 3 ; les lignes de découpage sont illustrées en zz sur la figure 3a. De la sorte, les cadres 3 sont enlevés et les conducteurs 16 affleurent les faces de l'empilement.

La figure 3b est une coupe analogue à celle de la figure 3a mais réalisée perpendiculairement à la précédente, selon un axe YY de la figure 1. Cette vue permet d'illustrer le dégagement du côté 11 des pastilles semi-conductrices.

Sur cette figure, on distingue les côtés 11 et 13 de la pastille semi-conductrice 1, recouverte de la partie centrale 4 du film isolant et entourée du cadre 3 de ce même film. On voit que les plots 15 de la pastille qui sont situés du côté 11 sont reliés par les conducteurs 17 aux pistes 41 portées par la partie centrale 4 ; ces pistes 41 sont reliées à l'autre de leurs extrémités par les conducteurs 18 aux pistes 31 du cadre 3. On a représenté en pointillés les plots 15 situés du côté 13 de la pastille, qui sont reliés directement par les conducteurs 16 à d'autres pistes 31 du cadre 3.

Comme précédemment, on a représenté le matériau 7 de solidarisation et les lignes de découpe zz correspondant à la ligne ZZ de la figure 1. La découpe zz effectuée du côté 11 peut soit être faite au ras de la pastille 1, soit sensiblement au milieu de la découpe 23, comme illustré sur les figures; dans ce dernier cas, l'empilement doit être ultérieurement poli de façon à faire affleurer la tranche des pastilles sur cette face de l'empilement pour permettre une bonne évacuation thermique par conduction.

Dans une variante de réalisation, on ne fait pas affleurer les tranches des pastilles mais on laisse subsister une certaine épaisseur du matériau isolant 7, qui soit suffisamment fine pour ne pas gêner l'évacuation thermique mais qui reste suffisante pour assurer la protection mécanique et l'étanchéité de l'empilement qui peuvent être nécessaires dans certaines applications.

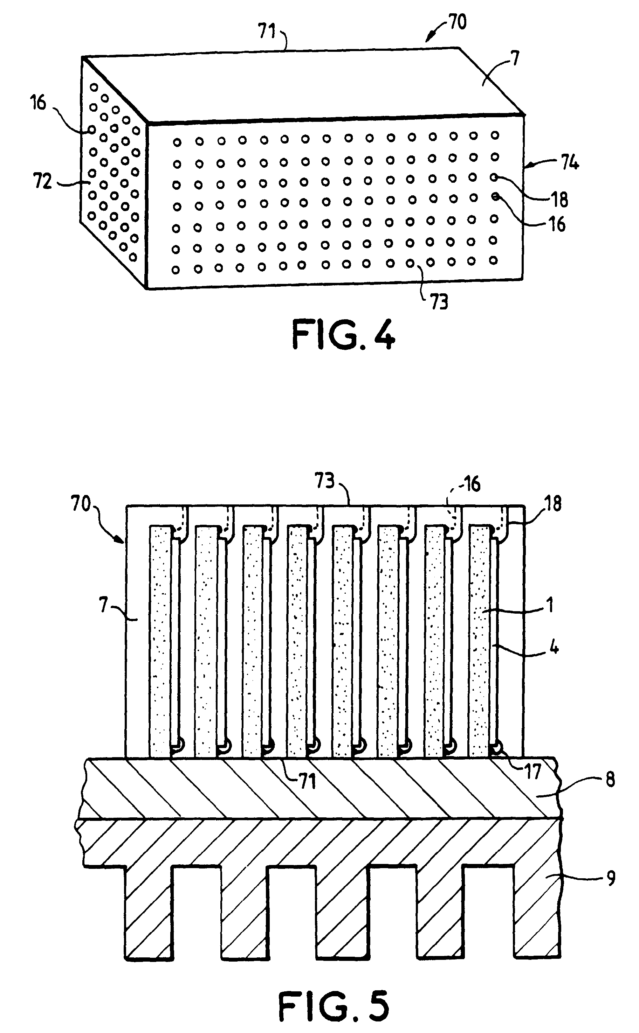

La figure 4 représente une vue en perspective de l'empilement, après découpe le long de la ligne ZZ de la figure 1.

L'empilement apparaît donc comme un bloc 70, formé du matériau diélectrique 7 sur certaines faces duquel affleurent les conducteurs 16 et 18.

Plus précisément, on a désigné par 71 la face de l'empilement qui correspond au côté 11 des pastilles 1, par 72 celle qui correspond à leur côté 12, par 73 celle qui correspond à leur côté 13 et par 74 celle qui correspond à leur côté 14. Sur la face 72 affleurent donc les conducteurs 16, reliant directement les plots 15 des pastilles aux pistes 31 du cadre avant sa découpe. La face 71, qui n'est pas visible sur la figure, est dépourvue de conducteurs. Sur la face 73 affleurent à la fois des conducteurs tels que 16 reliés directement aux plots des pastilles et des conducteurs tels que 18, qui sont reliés aux plots 15 situés du côté 11 par l'intermédiaire des pistes 41 de la partie centrale 4.

On a représenté sur cette figure les conducteurs 16 et 18 alignés selon des lignes et des colonnes, régulièrement espacés; cela l'est bien entendu à titre d'exemple et la répartition des conducteurs peut être adaptée selon les applications.

La figure 5 représente une vue en coupe de l'empilement selon l'invention, relié à des moyens d'évacuation thermique.

Sur cette figure, l'empilement 70 selon l'invention est formé par exemple par huit pastilles telles que 1, chacune munie de la partie centrale 4 du film 2 ; les plots des pastilles 1 sont reliés soit directement par les conducteurs 16 (représentées en pointillés) à la face 73 de l'empilement, soit indirectement par les conducteurs 17, 18 et la partie centrale 4 à cette même face 73. Comme expliqué ci-dessus, les plots des pastilles peuvent être également reliés aux faces 72 et 74 de l'empilement, non visibles sur la coupe de la figure 5.

Selon l'invention, la face 71 ne comportant pas de connexions électriques et sur laquelle affleurent les pastilles, est reliée à des moyens d'évacuation thermique. Dans le mode de réalisation représenté sur la figure, ces moyens sont par exemple constitués par un radiateur 9, comportant des ailettes et réalisé en un matériau bon conducteur de la chaleur et de préférence isolant électrique.

L'empilement 70 peut être relié directement au radiateur 9 si les coefficients de dilatation thermique des éléments 70 et 9 sont suffisamment proches; dans le cas où les pastilles 1 sont en silicium par exemple, le radiateur 9 peut être en nitrure d'aluminium, en carbure de silicium ou en diamant. Dans le cas contraire, l'empilement 70 peut être relié au radiateur 9 par l'intermédiaire d'une couche 8, comme représenté sur la figure 5, la couche 8 assurant l'adaptation thermo-mécanique nécessaire et étant par exemple réalisée dans l'un des matériaux mentionnés ci-dessus. Les éléments 70, 9 et éventuellement 8 sont, en tant que besoin, fixés les uns aux autres à l'aide d'une très mince couche de colle.

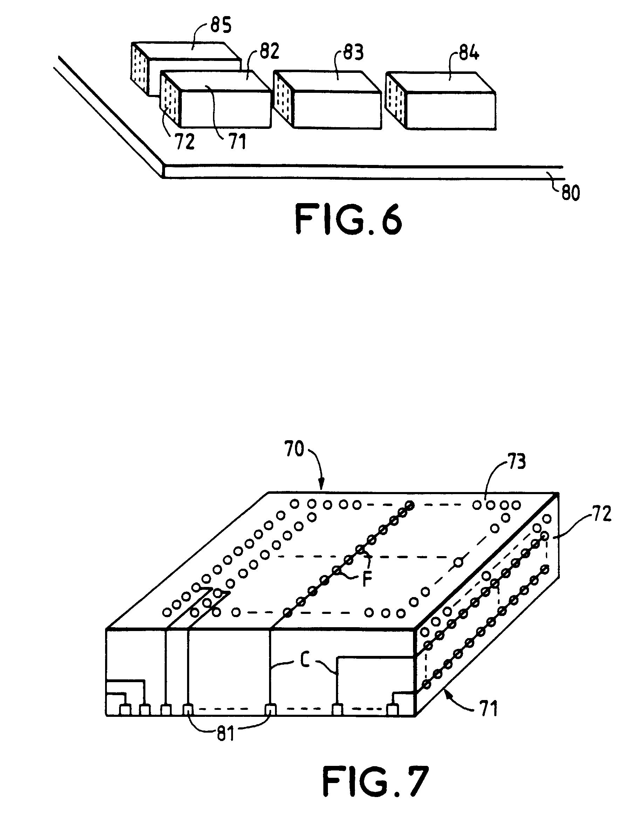

La figure 6 représente une vue en perspective partielle d'un circuit imprimé portant plusieurs empilements selon l'invention.

On a donc illustré un circuit imprimé 80 portant par exemple quatre empilements, repérés 82, 83, 84 et 85. Chacun des empilements est disposé sur le circuit imprimé par sa face 73 de sorte à pouvoir relier la face 71 à des moyens d'évacuation thermique (non représentés) comme illustré sur la figure 5; les extrémités des conducteurs connectant les plots des pastilles affleurent sur les faces 72, 73 et 74 de chacun des blocs.

La figure 7 représente un exemple de réalisation de l'interconnexion des pastilles formant un empilement 70, cette interconnexion étant réalisée sur les surfaces latérales de l'empilement.

Sur cette figure, on retrouve l'empilement 70 comportant les faces 72 et 73 sur lesquelles affleurent les conducteurs reliés, directement ou non, aux plots des pastilles; la face 71 sur laquelle affleurent les pastilles elles-mêmes est située, sur cette figure, dessous. Les conducteurs affleurant les faces 72 ou 73 sont indistinctement repérés F, qu'ils correspondent aux conducteurs 16 ou aux conducteurs 18 des figures précédentes. L'empilement 70 comporte en outre des plots 81, dits plots d'empilement, permettant de le connecter à des circuits extérieurs. Les conducteurs F sont à la fois interconnectés entre eux, quand nécessaire, et reliés aux plots d'empilement 81, également quand nécessaire, à l'aide de connexions C. A titre d'exemple, on a illustré les plots d'empilement 81 sur une face parallèle aux pastilles 1, au voisinage de la face 71, mais il est entendu qu'ils peuvent occuper toute position sur les faces de l'empilement, sauf sur la face 71.

Chacune des connexions C peut être réalisée de la façon suivante: on métallise l'ensemble des faces de l'empilement 70, puis on forme chacune des connexions C par deux gravures laser détruisant localement la couche métallique jusqu'à la couche isolante, réalisant ainsi l'isolation électrique de la connexion C du reste de la couche métallique. Les plots d'empilement 81 peuvent être avantageusement réalisés par la même technique de gravure laser.

Une autre méthode de réalisation des connexions C consiste à réaliser d'abord des rainures dans l'empilement, selon le dessin retenu pour les connexions C, au niveau où les conducteurs F affleurent, de sorte à dégager l'extrémité de ces derniers; puis on dépose une couche électriquement conductrice (métal par exemple) sur l'ensemble de l'empilement, faces et rainures; enfin, on enlève la couche conductrice des surfaces planes de l'empilement (par polissage ou par laser par exemple), de sorte à ne la laisser subsister que dans les rainures où elle réalise les connexions recherchées.

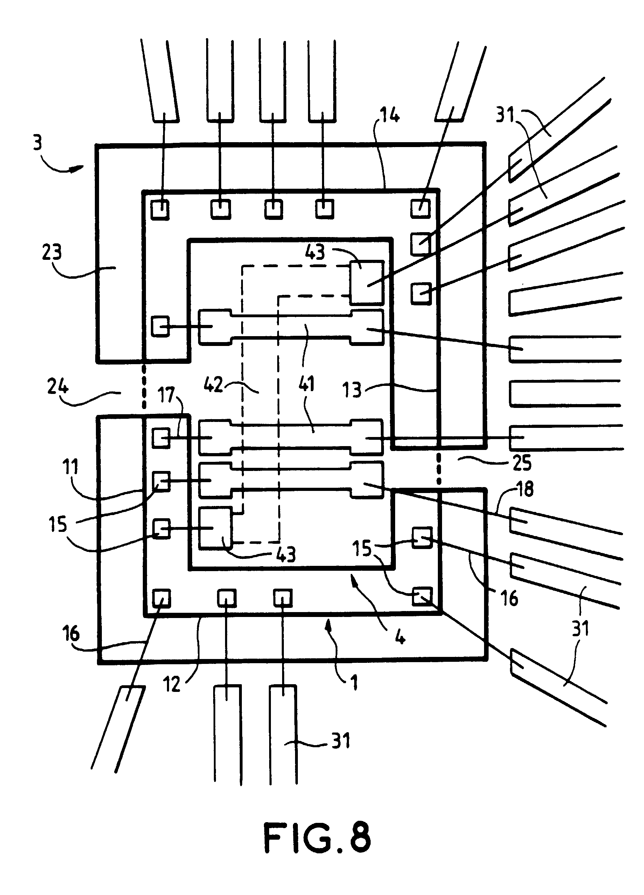

La figure 8 représente une variante de réalisation des moyens de connexion d'une pastille, utilisés dans le dispositif selon l'invention.

Cette figure est une vue partielle de dessus d'une pastille 1 et de ses moyens de connexion, portés par le film isolant comportant la partie centrale 4 et le cadre 3. Dans ce mode de réalisation, les moyens de connexion sont portés non plus par un film isolant unique mais par un film multicouche, formé d'une pluralité de couches électriquement conductrices (deux, par exemple) séparées par des couches isolantes, de façon à permettre plus de liberté au niveau du routage des pistes de la partie centrale.

Plus précisément, on a représenté partiellement le cadre 3 muni de ses pistes 31, ainsi que la pastille 1 munie de ses plots 15, recouverte de la partie centrale 4 qui est reliée au cadre 3 par des languettes 24 et 25. On notera que ces languettes ne sont pas nécessairement au nombre de deux ni de même largeur et qu'il n'est pas indispensable qu'elles soient disposées l'une en face de l'autre.

La constitution multicouche de la partie centrale 4 permet de réaliser des croisements des pistes portées par cette dernière partie, de façon à relier les plots 15 du côté 11 de la pastille à l'un quelconque des autres côtés du cadre 3. A titre d'exemple, on a représenté sur la figure, disposées sur la partie centrale 4, trois pistes 41 sensiblement rectilignes et permettant de faire émerger les plots 15 via les conducteurs 17 et 18 sur la face 73 de l'empilement une fois terminé; on a représenté également une piste 42, en traits pointillés parce que formée dans la couche conductrice inférieure, qui permet de relier entre eux deux plots 43 de la partie 4 formés, eux, sur la couche supérieure et reliés à la piste 42 par tous moyens connus (trous métallisés à travers la couche centrale isolante par exemple); l'un des plots 43 est situé par exemple en bas à gauche de la partie 4 et relié au plot 15 qui lui fait face; l'autre plot 43 est situé en haut à droite de cette même partie 4 et est relié à une piste 31 qui lui fait sensiblement face. Bien entendu, les plots et pistes de la partie centrale 4 sont formés dans l'une des couches conductrices et sont isolés du reste des couches.

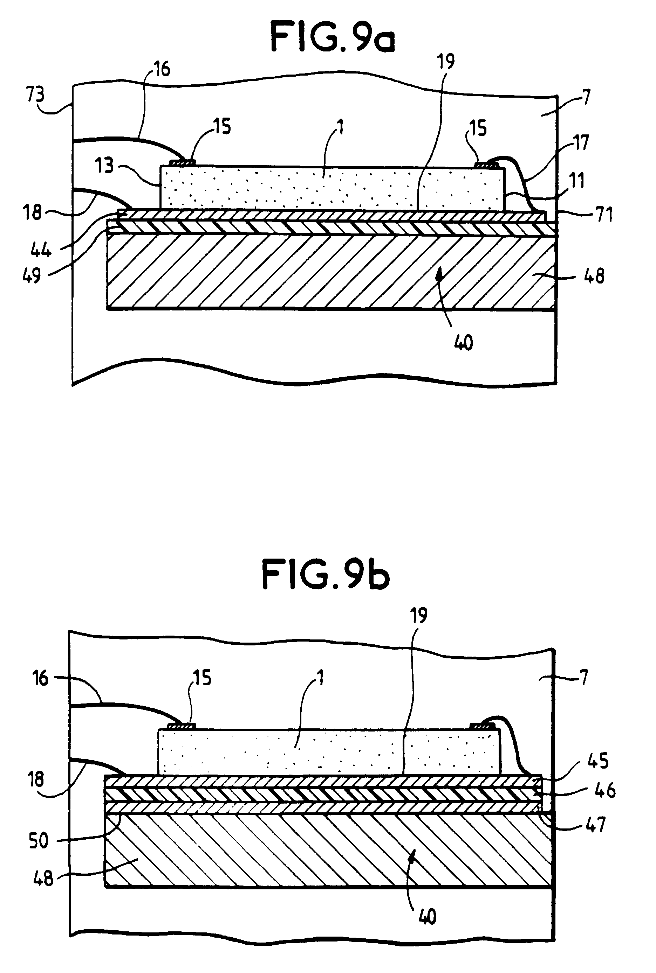

Les figures 9a et 9b représentent d'autres variantes de réalisation des moyens de connexion des pastilles.

La figure 9a représente une vue en coupe fractionnaire d'un empilement selon l'invention, dans laquelle on a représenté une seule pastille 1 et ses moyens de connexion, enrobés dans le matériau isolant 7. Pour la clarté du dessin, ce dernier n'a pas été hachuré bien que vu en coupe.

Selon cette variante de réalisation, l'empilement est réalisé comme décrit précédemment, sauf en ce qui concerne la position relative des moyens de connexion et de la pastille correspondante: en effet, le film et tout particulièrement sa partie centrale, maintenant repérée 40, est disposé sous la pastille 1, c'est-à-dire contre sa face arrière 19 qui ne porte pas les plots de connexion 15. La pastille 1 est donc fixée sur la partie centrale 40, le cas échéant par l'intermédiaire d'une colle isolante. Comme précédemment, certains des plots 15 sont reliés directement aux faces de l'empilement (par des conducteurs 16), par exemple la face 73 sur la figure. Au contraire, les plots 15 situés du côté 11 de la pastille sont reliés indirectement à ces mêmes faces, par l'intermédiaire de pistes portées par la partie centrale, ici repérées 44 et disposées sur une couche isolante 49, et l'intermédiaire des conducteurs 17 et 18. La face 71, comme précédemment, est donc dépourvue de connexions. Enfin, la partie centrale 40 comporte en outre une couche 48 d'un matériau bon conducteur de la chaleur, du cuivre par exemple, disposé sur la couche isolante 49 à l'opposé des pistes 44.

Dans ce mode de réalisation, c'est la partie centrale 40 et particulièrement la couche conductrice 48, qui affleure sur la face 71 et non directement le côté 11, à cause des conducteurs 17. Toutefois, une bonne évacuation thermique peut ici aussi être assurée, sous réserve de choisir de façon appropriée les matériaux constituant la partie 40 ainsi que ses dimensions, qui ne dépendent alors que des seuls paramètres thermiques.

La figure 9b est une vue analogue à celle de la figure 9a, qui illustre une variante de réalisation de la figure précédente dans laquelle la partie centrale est multicouche, de façon analogue à ce qui est décrit figure 8.

Plus précisément, la partie 40 comporte ici quatre couches: deux couches conductrices 45 et 47 séparées par une couche isolante 46 et la couche conductrice 48. L'une des couches conductrices, par exemple la couche 45, est disposée sur la face 16 de la pastille 1 et par exemple fixée par une colle isolante. Les conducteurs 17 et 18 sont reliés à des plots formés dans la couche 45. De façon analogue à ce qui est décrit sur la figure 8, certains de ces plots de la couche 45 sont reliés entre eux par des pistes également formées dans la couche 45, certains autres sont reliés entre eux par des pistes formées dans la couche 47 et sont reliés à cette couche 47 à travers la couche 46 par tous moyens connus, trous métallisés par exemple. A la couche 47 est fixée la couche thermiquement conductrice 48, le cas échéant par l'intermédiaire d'une colle isolante 50.

Dans l'une ou l'autre des variantes représentées sur les figures 9a et 9b, il est possible d'ajouter des puits thermiques (non représentés), réalisés en un matériau bon conducteur de la chaleur, traversant les couches séparant la couche 48 de la face arrière 19 et le cas échéant électriquement isolés de ces couches, améliorant la conduction thermique à travers la partie 40 et donc l'évacuation de la chaleur.

Il a été ainsi décrit un dispositif d'encapsulation et d'interconnexion en trois dimensions de pastilles semi-conductrices, qui est à la fois adapté au refroidissement par conduction et peu onéreux.

En effet, en ce qui concerne l'évacuation thermique, elle se fait soit directement par la tranche des pastilles (de préférence, le grand côté du rectangle), soit par les moyens de connexion des pastilles, dont le dimensionnement et les matériaux constitutifs peuvent alors être adaptés à la fonction thermique qui leur est affectée, ces derniers n'ayant localement pas de contraintes liées à la connectique électrique à remplir.

Quant aux coûts de fabrication, ceux-ci sont peu élevés du fait qu'on utilise des pastilles standards, des films d'usage courant dans la technologie de l'encapsulation des pastilles et des machines de câblage automatique, elles aussi utilisées couramment dans cette technologie, le nombre total des opérations nécessaires à la constitution d'un bloc étant par ailleurs très limité.

## Revendications

1. Procédé d'interconnexion de pastilles semi-conductrices (1), chacune ayant une face inférieure, une face supérieure opposée à la face inférieure et quatre côtés, et comportant des plots de connexion (15), le procédé comportant successivement les étapes suivantes :
- une première étape de prolongation des plots (15) de chaque pastille à l'aide de moyens de connexion comportant des pistes (41, 31) conductrices disposées sur un film isolant (2), les pistes étant reliées aux plots à l'aide de conducteurs (16, 17, 18) ;
- une deuxième étape d'empilement (70) des pastilles (1) et solidarisation de ces dernières et des conducteurs dans un matériau électriquement isolant (7), de sorte que les conducteurs affleurent les faces latérales de l'empilement ;
- une troisième étape de formation de connexions électriques (C) entre les conducteurs, sur les faces latérales de l'empilement;
le procédé étant caractérisé par le fait que :
- lors de la première étape, les pistes sont reliées aux plots vers au maximum trois côtés (12, 13, 14) de la pastille ;
- lors de la deuxième étape, les conducteurs affleurent les faces latérales de l'empilement à l'exception au moins de la face latérale (71), dite quatrième face latérale, située du quatrième côté (11) des pastilles ;
- lors de la troisième étape, les connexions sont formées sur les faces latérales de l'empilement autres que la quatrième face latérale, cette dernière étant reliée à des moyens d'évacuation thermique.

2. Procédé selon la revendication 1, caractérisé par le fait que les moyens de connexion sont formés, pour chaque pastille, par les conducteurs et le film isolant (2), ce dernier comportant un cadre (3) et une partie centrale (4), cette dernière ayant une surface voisine de celle de la pastille, la première étape consistant à disposer la pastille au droit de la partie centrale, à relier les plots (15) de chaque pastille, chacun, à l'aide d'un conducteur (16) vers une piste conductrice (31) située sur l'un des trois côtés du cadre qui sont situés en vis-à-vis desdits trois côtés (12, 13, 14) de la pastille, les plots (15) situés du quatrième côté (11) de la pastille (1) étant reliés, chacun, à l'aide d'un conducteur (17) à une piste conductrice (41) portée par la partie centrale, puis à l'aide d'un autre conducteur (18) à une piste conductrice (31) portée par l'un des trois côtés du cadre.

3. Procédé selon la revendication 2, caractérisé par le fait que la partie centrale (4) est de dimensions inférieures à celles de la pastille (1) et qu'elle est disposée sur la face de la pastille qui porte ses plots (15).

4. Procédé selon la revendication 2, caractérisé par le fait que la partie centrale (4) est de dimensions supérieures à celles de la pastille (1) et qu'elle est disposée sur la face arrière (19) de la pastille, qui ne porte pas ses plots (15).

5. Procédé selon l'une des revendications 2 à 4, caractérisé par le fait que la partie centrale est de type multicouche, comportant une pluralité de couches électriquement conductrices, séparées par des couches isolantes.

6. Procédé selon l'une des revendications 2 à 5, caractérisé par le fait que, lors de la deuxième étape, l'empilement (70) est en outre découpé (ZZ) entre la partie centrale (4) et le cadre (3), de sorte à ôter ce dernier.

7. Procédé selon les revendications 4 et 6, caractérisé par le fait que la découpe est réalisée ou complétée de sorte à faire affleurer le quatrième côté (11) des pastilles (1) sur une face (71) de l'empilement (70).

8. Procédé selon l'une des revendications précédentes, caractérisé par le fait que la troisième étape se décompose en deux sous-étapes:
- la première sous-étape consistant en un dépôt d'une couche conductrice sur l'ensemble des faces de l'empilement (70) ;
- la deuxième sous-étape consistant en une gravure par laser de la couche conductrice pour former des connexions électriques (C) reliant les conducteurs (F) entre eux.

9. Procédé selon l'une des revendications 1 à 7, caractérisé par le fait que la troisième étape se décompose en les sous-étapes suivantes :
- réalisation de rainures dans l'empilement au niveau où les conducteurs affleurent et selon le dessin souhaité pour les connexions (C) ;
- dépôt d'une couche conductrice sur l'ensemble de l'empilement rainuré ;
- suppression de la couche conductrice sur les surfaces planes de l'empilement, ne la laissant subsister que dans les rainures où elle forme les connexions.

10. Procédé selon l'une des revendications précédentes, caractérisé par le fait que lors de la troisième étape sont formés en outre des plots dits d'empilement (81), destinés à la connexion de l'empilement avec des circuits extérieurs, et que les connexions électriques (C) relient entre eux les conducteurs (F) et les plots d'empilement (81).

11. Dispositif d'encapsulation de pastilles semi-conductrices (1), chacune ayant une face inférieure, une face supérieure opposée à la face inférieure et quatre côtés, et comportant des plots de connexion (15), le dispositif comportant des moyens de connexion pour chacune des pastilles, ces moyens de connexion comportant des pistes conductrices disposées sur un film isolant (2), reliées aux plots à l'aide de conducteurs et assurant le prolongement des plots (15) des pastilles vers les côtés de ces pastilles, les pastilles et leurs moyens de connexion étant rendus solidaires les uns des autres à l'aide d'un matériau (7) électriquement isolant pour former un empilement (70), de sorte que les conducteurs affleurent les faces latérales de l'empilement, que la liaison électrique des conducteurs entre eux est effectuée par des connexions (C) réalisées sur les faces latérales de l'empilement ; le dispositif étant caractérisé par le fait que les moyens de connexion assurent le prolongement des plots des pastilles vers au maximum trois cotés (12, 13, 14) des pastilles ; que les conducteurs affleurent les faces latérales de l'empilement à l'exception au moins de la face latérale (71), dite quatrième face latérale, située au quatrième côté (11) des pastilles ; que les connexions sont réalisées sur les faces latérales de l'empilement autres que la quatrième face latérale, et que cette dernière est reliée à des moyens d'évacuation thermique.

12. Dispositif selon la revendication 11, caractérisé par le fait que ladite face (71) de l'empilement située du quatrième côté des pastilles ne comporte pas de conducteurs (F), que l'empilement comporte en outre des plots d'empilement (81) formés sur une ou plusieurs de ses faces à l'exception de ladite face latérale (71), ces plots d'empilement étant destinés à la connexion de l'empilement avec des circuits extérieurs, et que les connexions (C) assurent en outre la liaison d'au moins certains des conducteurs avec les plots d'empilement.

13. Dispositif selon l'une des revendications 11 ou 12, caractérisé par le fait que les moyens d'évacuation thermique comportent un radiateur (9) réalisé en matériau bon conducteur de chaleur.

14. Dispositif selon l'une des revendications 10 à 13, caractérisé par le fait que les conducteurs (16, 17, 18) sont des fils ou des rubans.

## Patentansprüche

1. Verfahren zum Anschluß von Halbleiterchips (1), die je eine Unterseite, eine der Unterseite gegenüberliegende Oberseite und vier Kanten sowie Anschlußpunkte (15) besitzen, wobei das Verfahren nacheinander folgende Schritte enthält:
- in einem ersten Schritt werden die Anschlußpunkte (15) jedes Chips mithilfe von Anschlußmitteln bestehend aus auf einen isolierenden Film (2) aufgebrachten leitenden Bahnen (41, 31) verlängert, die an die Anschlußpunkte mithilfe von Leitern (16, 17, 18) angeschlossen sind;
- in einem zweiten Schritt werden die Chips (1) zu einem Stapel (70) angeordnet und zusammen mit den Leitern in einem elektrisch isolierenden Material (7) zusammengefügt derart, daß die Leiter an den seitlichen Oberflächen des Stapels zutage treten,
- in einem dritten Schritt werden elektrische Verbindungen (C) zwischen den Leitern auf den seitlichen Außenflächen des Stapels gebildet;
dadurch gekennzeichnet, daß
- während des ersten Schritts die leitenden Bahnen an die Anschlußpunkte von höchstens drei Kanten (12, 13, 14) des Chips angeschlossen werden,
- während des zweiten Schritts die Leiter an den seitlichen Außenflächen des Stapels mit Ausnahme mindestens der vierten seitlichen Außenfläche (71) zutage treten, die der vierten Kante (11) der Chips benachbart ist,
- während des dritten Schritts die Verbindungen an den seitlichen Außenflächen des Stapels mit Ausnahme der vierten seitlichen Außenfläche hergestellt werden, während an diese vierte seitliche Außenfläche Wärmeabfuhrmittel gekoppelt werden.

2. Verfahren nach Anspruch 1, dadurch gekennzeichnet, daß die Anschlußmittel für jeden Chip von den Leitern und dem isolierenden Film (2) gebildet werden, der einen Rahmen (3) und einen zentralen Bereich (4) besitzt, wobei letzterer eine Oberfläche ähnlich der des Chips besitzt, wobei der erste Schritt darin besteht, den Chip in Höhe des zentralen Bereichs anzuordnen, die Anschlußpunkte (15) jedes Chips einzeln mithilfe je eines Leiters (16) an eine leitende Bahn (31) anzuschließen, die sich auf einer der drei Seiten des Rahmens gegenüber den drei Kanten (12, 13, 14) des Chips befinden, während die Anschlußpunkte (15) der vierten Kante (11) des Chips (1) je mithilfe eines Leiters (17) an eine leitende Bahn (41), die sich auf dem zentralen Bereich befindet, und dann mithilfe eines weiteren Leiters (18) an eine leitende Bahn (31) angeschlossen werden, die sich auf einer der drei Seiten des Rahmens befindet.

3. Verfahren nach Anspruch 2, dadurch gekennzeichnet, daß der zentrale Bereich (4) geringere Abmessungen als der Chip (1) besitzt und auf der Seite des Chips liegt, die dessen Anschlußpunkte (15) trägt.

4. Verfahren nach Anspruch 2, dadurch gekennzeichnet, daß der zentrale Bereich (4) größere Abmessungen als der Chip (1) besitzt und auf der Rückseite (19) des Chips liegt, auf der sich keine Anschlußpunkte (15) befinden.

5. Verfahren nach einem der Ansprüche 2 bis 4, dadurch gekennzeichnet, daß der zentrale Bereich vom Mehrschichtentyp ist und mehrere durch elektrisch isolierende Schichten getrennte elektrisch leitende Schichten enthält.

6. Verfahren nach einem der Ansprüche 2 bis 5, dadurch gekennzeichnet, daß während des zweiten Schritts der Stapel (70) außerdem zwischen dem zentralen Bereich (4) und dem Rahmen (3) zerschnitten wird (ZZ), sodaß der Rahmen wegfällt.

7. Verfahren nach den Ansprüchen 4 bis 6, dadurch gekennzeichnet, daß das Zerschneiden so durchgeführt oder vervollständigt wird, daß die vierte Kante (11) der Chips (1) auf einer seitlichen Außenfläche (71) des Stapels (70) zutage tritt.

8. Verfahren nach einem der vorstehenden Ansprüche, dadurch gekennzeichnet, daß der dritte Schritt in zwei Teilschritte zerfällt, wobei
- der erste Teilschritt darin besteht, eine leitende Schicht auf alle Außenflächen des Stapels (70) aufzubringen,
- und der zweite Teilschritt darin besteht, mit einem Laser die leitende Schicht zu gravieren, um elektrische Verbindungen (C) zwischen den Leitern (F) herzustellen.

9. Verfahren nach einem der Ansprüche 1 bis 7, dadurch gekennzeichnet, daß der dritte Schritt in folgende Teilschritte zerfällt:
- Herstellung von Rinnen am Stapel an der Stelle, wo die Leiter zutage treten, und gemäß dem gewünschten Schema für die Verbindungen (C),
- Aufbringen einer leitenden Schicht auf den ganzen mit Rinnen versehenen Stapel,
- Entfernung der leitenden Schicht auf den ebenen Außenflächen des Stapels mit Ausnahme des Inneren der Rinnen, wo diese Schicht die Verbindungen bildet.

10. Verfahren nach einem der vorstehenden Ansprüche, dadurch gekennzeichnet, daß während des dritten Schritts außerdem Stapelanschlußpunkte (81) gebildet werden, die zum Anschluß des Stapels an äußere Schaltkreise dienen, und daß die elektrischen Verbindungen die Leiter (F) und die Stapelanschlußpunkte (81) miteinander verbinden.

11. Vorrichtung zum Einkapseln von Halbleiterchips (1), die je eine Unterseite, eine der Unterseite gegenüberliegende Oberseite und vier Kanten sowie Anschlußpunkte (15) besitzen, wobei die Vorrichtung für jeden Chip Anschlußmittel mit leitenden Bahnen auf einem isolierenden Film (2) besitzt, die mit den Anschlußpunkten verbunden sind und die Verlängerung der Anschlußpunkte (15) der Chips an die Seiten dieser Chips bewirken, wobei die Chips und ihre Anschlußmittel mithilfe eines elektrisch isolierenden Materials (7) zu einem Stapel (70) zusammengefügt werden, sodaß die Leiter an den seitlichen Außenflächen des Stapels zutage treten, daß die elektrische Verbindung der Leiter untereinander über Verbindungen (C) erfolgt, die auf den seitliche Außenflächen des Stapels realisiert sind, dadurch gekennzeichnet, daß die Anschlußmittel die Verlängerung der Anschlußpunkte der Chips auf höchstens drei Kanten (12, 13, 14) der Chips bewirken, daß die Leiter an den seitliche Außenflächen des Stapels mit Ausnahme mindestens einer vierten seitlichen Außenfläche (71) zutage treten, die der vierten Kante (11) der Chips benachbart ist, daß die Verbindungen auf den seitlichen Außenflächen des Stapels mit Ausnahme der vierten seitlichen Außenfläche erfolgen und daß die vierte seitliche Außenfläche mit Wärmeabfuhrmitteln gekoppelt ist.

12. Vorrichtung nach Anspruch 11, dadurch gekennzeichnet, daß die vierte seitliche Außenfläche (71) des Stapels, die der vierten Kante der Chips benachbart ist, keine Leiter (F) enthält, daß der Stapel außerdem auf einer oder mehreren seiner Außenflächen mit Ausnahme der vierte seitliche Außenfläche (71) Stapelanschlußpunkte (81) besitzt, die zum Anschluß des Stapels an äußere Schaltkreise bestimmt sind, und daß die Verbindungen (C) außerdem mindestens bestimmte der Leiter mit den Stapelanschlußpunkten verbinden.

13. Vorrichtung nach einem der Ansprüche 11 und 12, dadurch gekennzeichnet, daß die Mittel zur Wärmeabfuhr einen Strahlungskörper (9) aufweisen, der aus einem gut wärmeleitenden Material besteht.

14. Vorrichtung nach einem der Ansprüche 10 bis 13, dadurch gekennzeichnet, daß die Leiter (16, 17, 18) Drähte oder Bänder sind.

## Claims

1. Method of interconnection of semiconductor chips (1), each having a lower face, an upper face opposite the lower face, and four sides, and including connection pads (15), the method comprising, in succession, the following steps:
- a first step of extending the pads (15) of each chip with the aid of connection means comprising conductive tracks (41, 31) placed on an insulating film (2), the tracks being connected to the pads with the aid of conductors (16, 17, 18);
- a second step of stacking (70) the chips (1) and fastening of the latter and of the conductors in an electrically insulating material (7), so that the conductors are flush with the side faces of the stack;
- a third step of forming electrical connections (C) between the conductors, on the side faces of the stack;
the method being characterized in that:
- during the first step, the tracks are connected to the pads on at most three sides (12, 13, 14) of the chip;
- during the second step, the conductors are flush with the side faces of the stack except for at least the side face (71), called the fourth side face, located on the fourth side (11) of the chips;
- during the third step, the connections are formed on the side faces of the stack other than the fourth side face, the latter being connected to heat dissipation means.

2. Method according to Claim 1, characterized in that the connection means are formed, for each chip, by the conductors and the insulating film (2), the latter having a frame (3) and a central part (4), the latter having a surface area similar to that of the chip, the first step consisting in placing the chip in line with the central part, in connecting the pads (15) of each chip, each, with the aid of a conductor (16), to a conductive track (31) located on one of the three sides of the frame, these three sides being located opposite the said three sides (12, 13, 14) of the chip and the pads (15) located on the fourth side (11) of the chip (1) being connected, each with the aid of a conductor (17), to a conductive track (41) carried by the central part and then, with the aid of another conductor (18), to a conductive track (31) carried by one of the three sides of the frame.

3. Method according to Claim 2, characterized in that the central part (4) has dimensions which are smaller than those of the chip (1) and that it is placed on that face of the chip which carries its pads (15).

4. Method according to Claim 2, characterized in that the central part (4) has dimensions which are greater than those of the chip (1) and that it is placed on that rear face (19) of the chip which does not carry its pads (15).

5. Method according to one of Claims 2 to 4, characterized in that the central part is of the multilayer type, having a plurality of electrically conductive layers separated by insulating layers.

6. Method according to one of Claims 2 to 5, characterized in that, during the second step, the stack (70) is furthermore cut (ZZ) between the central part (4) and the frame (3) so as to remove the latter.

7. Method according to Claims 4 and 6, characterized in that the cutting is carried out, or completed, so as to make the fourth side (11) of the chips (1) be flush on a side face (71) of the stack (70).

8. Method according to one of the preceding claims, characterized in that the third step is divided into two sub-steps:
- the first sub-step consisting in depositing a conductive layer over all the faces of the stack (70);
- the second sub-step consisting in laser-etching the conductive layer in order to form electrical connections (C) connecting the conductors (F) together.

9. Method according to one of Claims 1 to 7, characterized in that the third step is divided into the following sub-steps:
- formation of grooves in the stack in the region where the conductors are flush and in the desired pattern for the connections (C);
- deposition of a conductive layer over the entire grooved stack;
- removal of the conductive layer on the plane surfaces of the stack, leaving it to remain only in the grooves where it forms the connections.

10. Method according to one of the preceding claims, characterized in that during the third step so-called stack pads (81), intended for connecting the stack to external circuits, are furthermore formed and in that the electrical connections (C) connect the conductors (F) and the stack pads (81) together.

11. Device for the encapsulation of semiconductor chips (1), each having a lower face, an upper face opposite the lower face, and four sides, and including connection pads (15), the device comprising connection means for each of the chips, these connection means comprising conductive tracks placed on an insulating film (2), the said conductive tracks being connected to the pads with the aid of conductors and providing the extension of the pads (15) of the chips on the sides of these chips, the chips and their connection means being fastened to each other with the aid of an electrically insulating material (7) in order to form a stack (70), so that the conductors are flush with the side faces of the stack, and so that the conductors are connected together electrically by connections (C) made on the side faces of the stack, the device being characterized in that the connection means provide the extension of the pads of the chips on at most three sides (12, 13, 14) of the chips, in that the conductors are flush with the side faces of the stack except for at least the side face (71), called the fourth side face, located on the fourth side (11) of the chips, in that the connections are made on the side faces of the stack other than the fourth side face and in that the latter is connected to heat dissipation means.

12. Device according to Claim 11, characterized in that the said face (71) of the stack which is located on the fourth side of the chips does not have conductors (F), that the stack furthermore includes stack pads (81) formed on one or more of its faces except for the said side face (71), these stack pads being intended for connecting the stack to external circuits, and in that the connections (C) furthermore connect at least some of the conductors to the stack pads.

13. Device according to either of Claims 11 and 12, characterized in that the heat dissipation means comprise a heat sink (9) made of a material which is a good heat conductor.

14. Device according to one of Claims 10 to 13, characterized in that the conductors (16, 17, 18) are wires or ribbons.
